# EUROPEAN PATENT APPLICATION

(11) **EP 2 149 909 A1**
(43) Date of publication of application: **03.02.2010**
(21) Application number: 08703573.9
(22) Date of filing: 21.01.2008
(51) Int. Cl.: H01L 29/786, H01L 21/336, H01L 21/8234, H01L 27/08, H01L 27/088

(54) **SEMICONDUCTOR DEVICE AND ITS MANUFACTURING METHOD**

(30) Priority: 21.05.2007 JP 2007134465
(71) Applicant: Sharp Kabushiki Kaisha, Osaka-shi, Osaka 545-8522 (JP)
(72) Inventor: KITAKADO, Hidehito, Osaka-shi, Osaka 545-8522 (JP)
(74) Representative: Müller - Hoffmann & Partner
(86) International application number: PCT/JP2008/050723
(87) International publication number: WO 2008/142873

(57) **Abstract**

The present invention provides a semiconductor device including thin film transistors that have different characteristics on the same substrate and that have high performance and high reliability and a production method thereof.
The present invention is a semiconductor device including, on a main surface of a substrate, a structure in which a semiconductor layer, an insulating film, and a wiring are stacked in this order from a side of the substrate,
wherein the semiconductor layer includes a first semiconductor layer and a second semiconductor layer,
the first semiconductor layer has a first channel region and a first source-drain region having a first contact part that is in contact with the wiring,
the second semiconductor layer has a second channel region and a second source-drain region having a second contact part that is in contact with the wiring,
the insulating film includes a first insulating film and a second insulating film, stacked in this order from the side of the substrate,
the first insulating film is formed on the second channel region, except for on the first channel region and the first and second contact parts, and
the second insulating film is formed on the first channel region, a part facing the second channel region of the first insulating film, the first source-drain region except for the first contact part, and the second source-drain region except for the second contact part.

## Description

### TECHNICAL FIELD

The present invention relates to a semiconductor device and a production method thereof. More particularly, the present invention relates to a semiconductor device suitably used in a display device such as a liquid crystal display device and also relates to a production method thereof.

### BACKGROUND ART

A semiconductor device is an active element-including electronic device using electrical characteristics of a semiconductor. Such a semiconductor device is being widely used in an audio device, a communication device, a computer, an electric appliance, and the like. A semiconductor device including a TFT (thin film transistor) is particularly being widely applied in a pixel switching element of an active matrix liquid crystal display device, a driver circuit, and the like.

In recent year, for mobile display devices (displays), reductions in electrical power consumption and size, and improvements in performance, operation speed, reliability, and resolution, and the like, are needed. Under this circumstance, displays satisfying these demands are being researched and developed. For these demands, a technology of improving performances of TFTs constituting various circuits of a display device and a technology of forming TFTs whose characteristics are different and appropriate for a circuit where it is arranged, are important. So a technology of forming TFTs with different characteristics on the same substrate is being researched and developed.

According to conventional technologies, in order to form a TFT driven at a low voltage (forexample, 5V or less) (hereinafter, also referred to as a "low voltage transistor") and a TFT driven at a high voltage (for example, 10V or more) (hereinafter, also referred to as a "high voltage transistor"), a method of forming gate insulating films different in thickness between the two TFTs is being researched and developed. More specifically, a technology of forming the gate insulating film of the low voltage transistor to have a single-layer structure composed of a first gate insulating film, and forming the gate insulating film of the high voltage transistor to have a multi-layer structure composed of first and second gate insulating films is being researched and developed. In this case, however, when the first gate insulating film is etched, an edge of a semiconductor layer that is formed below the first gate insulating film might be exposed, and thereby a base insulating film that is formed below the semiconductor layer might be etched (the base insulating film might be provided with spot-facing). As a result, coating property of the second gate insulating film that is to be formed after that might be deteriorated, which leads to a reduction in breakdown withstand voltage of the gate insulating film.

For example, Patent Document 1 discloses the following production method of a semiconductor device, as a technology of preventing spot-facing in a base insulating film that is below a semiconductor layer. First and second semiconductor layers are formed on the base insulating film, and thereon, an insulating film is further formed. The insulating film that is positioned on the channel-forming region of the first semiconductor layer is removed by etching using the first semiconductor layer as an etching stopper.

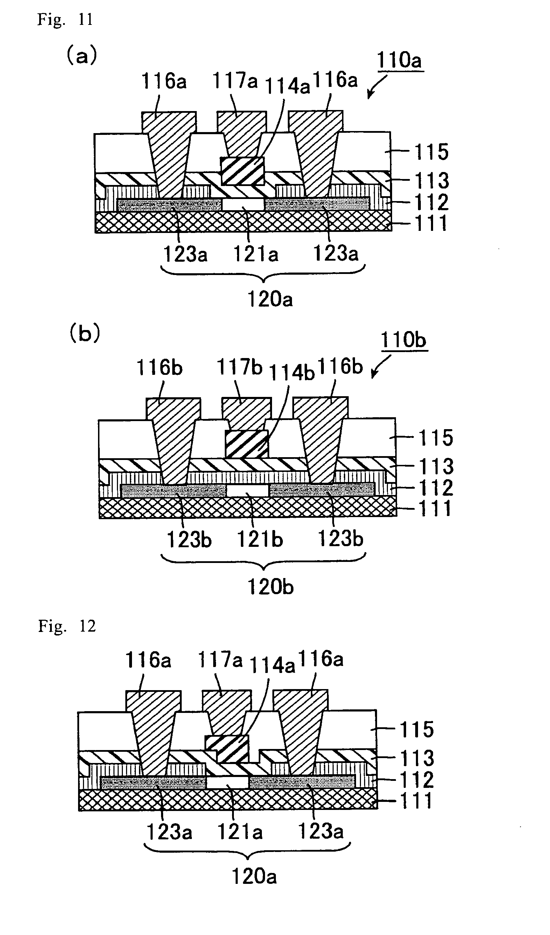

The configuration of the semiconductor device disclosed in Patent Document 1 is mentioned below in more detail. Fig. 11 is a cross-sectional view schematically showing a configuration of a conventional semiconductor device in accordance with Patent Document 1. Fig. 11(a) shows a low voltage transistor. Fig. 11(b) shows a high voltage transistor. The conventional semiconductor device includes TFTs 110a and 110b on the same substrate 111, as shown in Fig. 11. The TFT 110a functions as a low voltage transistor, and the TFT 110b functions as a high voltage transistor.

The TFT 110a has a structure in which an island-shaped semiconductor layer 120a, a first insulating film 112, a second insulating film 113, and a gate electrode 114a are formed in this order from a substrate 111 side. The TFT 110a further includes an interlayer insulating film 115 covering these members, and wirings 116a and 117b formed on the film 115. The semiconductor layer 120a has a channel region 121a and a source-drain region 123a.

The TFT 110b has, similarly to the TFT 110a, a structure in which an island-shaped semiconductor layer 120b, the first insulating film 112, the second insulating film 113, and a gate electrode 114b are formed in this order from the TFT 111 side. The TFT 110b further includes the interlayer insulating film 115 covering these members, and wirings 116b and 117b formed on the film 115. The semiconductor layer 120b has a channel region 121b and a source-drain region 123b. Thus, the TFT 110b includes a gate insulating film composed of the first insulating film 112 and the second insulating film 113.

The first insulating film 112 is formed to cover an edge of the semiconductor layers 120a and 120b so as to prevent spot-facing of a base insulating film (not shown) formed between the substrate 111, and the semiconductor layers 120a and 120b. Further, only a portion that is positioned in the channel region 121a of the TFT 110a of the first insulating film 112 is removed by etching. That is, the TFT 110a includes a gate insulating film composed of: the first insulating film 112; and the second insulating film 113 except for a part that is positioned in the channel region 121a.
[Patent Document 1]
Japanese Kokai Publication No. 2005-183774

### DISCLOSURE OF INVENTION

In Patent Document 1, a two-layered insulating film is formed on the source-drain region 123a of the low voltage transistor (TFT 110a) and the source-drain region 123b of the high voltage transistor (TFT 110b) so that doping for the source-drain regions 123a and 123b is performed at one time. In this case, the insulating film on the channel region 121a of the TFT 110a has a single-layer structure, and the insulating film on the source-drain region 123a of the TFT 110a has a two-layered structure. Accordingly, as shown in Fig. 12, if misalignment of a resist for etching the first insulating film 112 occurs, the gate insulating film on the channel region 121a might have two-layered structure at an edge region of the gate electrode 114a, and/or the gate insulating film on the source-drain region 123a might have a single-layer structure on the outside of the edge of the gate electrode 114a. Such uneven two-layering of the gate insulating film on the channel region 121a leads to a variation in threshold voltage of the TFT 110a. Such a variation in thickness of the gate insulating film on the source-drain region 123a causes problems in a resistance value of the source-drain region 123a. Particularly, as shown in Fig. 12, if the gate insulating film has a two-layered structure on the source-drain region 123a having a contact part for connection to the wiring 116a, a doping amount of impurities in the contact part needs to be optimized in order to reduce a contact resistance between the wiring 116a and the source-drain region 123a. However, the optimum doping amount for the two-layered gate insulating film is too high for the single-layered gate insulating film that is positioned outside the edge of the gate electrode 114a. The silicon crystal in the semiconductor layer 120a might become amorphous silicon, which causes problems in characteristics, such as a resistance value of this region.

A method of providing the gate insulating film that is positioned on the inside of the edge of the gate electrode 114a with a two-layered structure so as not to prevent the influence on the resistance value of the source-drain region 123a on the outside of the edge of the gate electrode 114a is also mentioned. In this case, however, in the low voltage transistor, an increase in threshold voltage and a decrease in drain current might be generated. Typically, a smaller channel length is needed for a lower voltage transistor. If the channel length of the low voltage transistor is 2 µm, for example, the length of the two-layered region of the gate insulating film on the inside of the edge of the gate electrode 114a needs to be at least about 0.5 µm on each side, in view of misalignment. So the single-layered gate insulating film has a channel length of 1 micrometer. As a result, in the low voltage transistor, deterioration of characteristics such as an increase in threshold voltage and a reduction in drain current might be generated.

The present invention has been made in view of the above-mentioned state of the art. The present invention has an object to provide a high-performance and high-reliable semiconductor device that includes thin film transistors with different characteristics formed on the same substrate and also provide a production method of such a semiconductor device.

The present inventors made various investigations of a high-performance and high-reliable semiconductor device that includes thin film transistors with different characteristics formed on the same substrate and a production method of such a semiconductor device. The inventors noted a way of forming gate insulating films different in thickness between the TFTs with different characteristics. The inventors found that it can be possible to form transistors with different characteristics such as a low voltage transistor and a high voltage transistor on the same substrate while defects caused by problems and deterioration of characteristics are suppressed in the following embodiment: a semiconductor device semiconductor device including, on a main surface of a substrate, a structure in which a semiconductor layer, an insulating film, and a wiring are stacked in this order from a side of the substrate,
wherein the semiconductor layer includes a first semiconductor layer and a second semiconductor layer,
the first semiconductor layer has a first channel region and a first source-drain region having a first contact part that is in contact with the wiring,
the second semiconductor layer has a second channel region and a second source-drain region having a second contact part that is in contact with the wiring,
the insulating film includes a first insulating film and a second insulating film, stacked in this order from the side of the substrate,
the first insulating film is formed on the second channel region, except for on the first channel region and the first and second contact parts, and
the second insulating film is formed on the first channel region, a part facing the second channel region of the first insulating film, the first source-drain region except for the first contact part, and the second source-drain region except for the second contact part.
As a result, the above-mentioned problems have been admirably solved, leading to completion of the present invention.

That is, the present invention is a semiconductor device including, on a main surface of a substrate, a structure in which a semiconductor layer, an insulating film, and a wiring are stacked in this order from a side of the substrate,
wherein the semiconductor layer includes a first semiconductor layer and a second semiconductor layer,
the first semiconductor layer has a first channel region and a first source-drain region having a first contact part that is in contact with the wiring,
the second semiconductor layer has a second channel region and a second source-drain region having a second contact part that is in contact with the wiring,
the insulating film includes a first insulating film and a second insulating film, stacked in this order from the side of the substrate,
the first insulating film is formed on the second channel region, except for on the first channel region and the first and second contact parts, and
the second insulating film is formed on the first channel region, a part facing the second channel region of the first insulating film, the first source-drain region except for the first contact part, and the second source-drain region except for the second contact part.
According to this embodiment, a high-performance and high-reliable semiconductor device including TFTs with different characteristics formed on the same substrate can be provided.

The configuration of the semiconductor device of the present invention is not especially limited as long as it essentially includes such components. The semiconductor device may or may not include other components. The semiconductor device of the present invention may have a structure, on a main surface of a substrate, a semiconductor layer, an insulating film, a gate electrode, an interlayer insulating film, and a wiring are stacked in this order from a side of the substrate. Preferable embodiments of the semiconductor device of the present invention are mentioned in more detail below. The following embodiments may be appropriately employed in combination.

In order to provide a high-performance and high-reliable semiconductor device including a TFT having an LDD (lightly doped drain) structure suitable for a low voltage transistor and a TFT having an LDD structure suitable for a high voltage transistor, it is preferable that the first semiconductor layer further has a first low concentration impurity region with an impurity concentration lower than an impurity concentration of the first source-drain region,
the second semiconductor layer further has a second low concentration impurity region with an impurity concentration lower than an impurity concentration of the second source-drain region,
the first insulating film is formed on the second channel region and the second low concentration impurity region, except for on the first channel region, the first low concentration impurity region, and the first and second contact parts,
the second insulating film is formed on:
the first channel region;
the first low concentration impurity region;
a part facing the second channel region and the second low concentration impurity region of the first insulating film;
the first source-drain region except for the first contact part; and
the second source-drain region except for the second contact part, and
the first low concentration impurity region has a sheet resistance smaller than that of the second low concentration impurity region.

The sheet resistance of the first low concentration impurity region is preferably about 20 to 50 kΩ/□. The sheet resistance of the second low concentration impurity region is preferably about 40 to 150 kΩ/□. It is preferable that the first low concentration impurity region has an impurity concentration higher than that of the second low concentration impurity region. Further, it is preferable that the first low concentration impurity region has an impurity concentration lower than that of the first source-drain region. It is preferable that the second low concentration impurity region has an impurity concentration lower than that of the second source-drain region.

In order to improve breakdown withstand voltages of the first and second insulating films, it is preferable that the semiconductor device further includes a first gate electrode and a second gate electrode,
the first gate electrode being formed on the second insulating film to face the first channel region,
the second gate electrode being formed on the second insulating film to face the second channel region,
the first insulating film is formed on the second channel region, a part facing the first gate electrode of an edge of the first semiconductor layer, and a part facing the second gate electrode of an edge of the second semiconductor layer, except for on the first channel region and the first and second contact parts.

According to the semiconductor device of the present invention, in a region that is not referred to, the first and second insulating film may or may not be formed.

That is, the semiconductor device of the present invention may be in accordance with the following embodiment:
the first insulating film is formed at least on the second channel region, except for on the first channel region and the first and second contact parts, and
the second insulating film is formed at least on the first channel region, a part facing the second channel region of the first insulating film, the first source-drain region except for the first contact part, and the second source-drain region except for the second contact part.

Further, the semiconductor device of the present invention may be in accordance with the following embodiment:
the first insulating layer is formed at least on the second channel region and the second low concentration impurity region, except for on the first channel region, the first low concentration impurity region, and the first and second contact parts,
the second insulating film is formed at least on the first channel region, the first low concentration impurity region, a part facing the second channel region and the second low concentration impurity region of the first insulating film, the first source-drain region except for the first contact part, and the second source-drain region except for the second contact part.

In addition, the first insulating film may be formed at least on the second channel region, a part facing the first gate electrode of an edge of the first semiconductor layer, and a part facing the second gate electrode of an edge of the second semiconductor layer, except for on the first channel region and the first and second contact parts.

The present invention is also a production method of a semiconductor device having, on a main surface of a substrate, a structure in which a semiconductor layer, an insulating film, and a wiring are stacked in this order from a side of the substrate,
the semiconductor layer including a first semiconductor layer and a second semiconductor layer,
the first semiconductor layerhaving a first channel region and a first source-drain region having a first contact part that is in contact with the wiring,
the second semiconductor layer having a second channel region and a second source-drain region having a second contact part that is in contact with the wiring,
the insulating film including a first insulating film and a second insulating film, stacked in this order from the side of the substrate,
the production method including the steps of:
forming the first insulating film on the second channel region, except for on the first channel region and the first and second contact parts; and
forming the second insulating film on the first channel region, a part facing the second channel region of the first insulating film, and the first and second source-drain regions. According to this, TFTs with different characteristics are formed on the same substrate and a high-performance and high-reliable semiconductor device can be provided.

The production method of the semiconductor device according to the present invention is not especially limited as long as these steps are included. The production method may include other steps. The production method of the semiconductor device of the present invention may be a production method of a semiconductor device having, on a main surface of a substrate, a semiconductor layer, an insulating film, a gate electrode, an interlayer insulating film, and a wiring are stacked in this order from a side of the substrate.
Preferable embodiments of the production method of the semiconductor device of the present invention are mentioned in more detail below. The following embodiments may be employed in combination.

In order to produce a high-performance and high-reliable semiconductor device including a TFT having an LDD structure suitable for a low voltage transistor and a TFT having an LDD structure suitable for a high voltage transistor, it is preferable that the first semiconductor layer further having a first low concentration impurity region with an impurity concentration lower than an impurity concentration of the first source-drain region,
the second semiconductor layer further having a second low concentration impurity region with an impurity concentration lower than an impurity concentration of the second source-drain region,
the production method includes the steps of:
forming the first insulating film on the second channel region and the second low concentration impurity region, except for on the first channel region, the first low concentration impurity region, and the first and second contact parts;
forming the second insulating film on: the first channel region; the first low concentration impurity region; a part facing the second channel region and the second low concentration impurity region of the first insulating film; and the first and second source-drain regions; and
forming a first gate electrode on a part facing the first channel region of the second insulating film and forming a second gate electrode on a part facing the second channel region of the second insulating film; and
doping the first and second semiconductor layers with an impurity using the first and second gate electrodes as a mask.

The sheet resistance of the first low concentration impurity region is preferably about 20 to 50 kΩ/□. The sheet resistance of the second low concentration impurity region is preferably about 40 to 150 kΩ/□. It is preferable that the first low concentration impurity region has an impurity concentration higher than that of the second low concentration impurity region. Further, it is preferable that the first low concentration impurity region has an impurity concentration lower than that of the first source-drain region. It is preferable that the second low concentration impurity region has an impurity concentration lower than that of the second source-drain region.

In order to improve breakdown withstand voltages of the first and second insulating films, it is preferable that the semiconductor device further includes: the first gate electrode that is formed on the second insulating film to face the first channel region; and
the second gate electrode that is formed on the second insulating film to face the second channel region,
wherein the production method includes a step of forming the first insulating film on the second channel region, a part facing the first gate electrode of an edge of the first semiconductor layer, and a part facing the second gate electrode of an edge of the second semiconductor layer, except for on the first channel region and the first and second contact parts

According to the production method of the semiconductor device of the present invention, in a region that is not referred to, the first and second insulating film may or may not be formed.

That is, the production method of the semiconductor device may be in accordance with the following embodiment.
The production method may include the steps of:
forming the first insulating film at least on the second channel region, except for on the first channel region and the first and second contact parts; and
forming the second insulating film at least on the first channel region, a part facing the second channel region of the first insulating film, and the first and second source-drain regions.

In addition, the production method of the semiconductor device may be in accordance with the following embodiment.
The production method may include the steps of:
forming the first insulating film at least on the second channel region and the second low concentration impurity region, except for on the first channel region, the first low concentration impurity region, and the first and second contact parts; and
forming the second insulating film at least on the first channel region, the first low concentration impurity region, a part facing the second channel region and the second low concentration impurity region of the first insulating film, and the first and second source-drain regions.

In addition, the production method may include a step of forming the first insulating film at least on the second channel region, a part facing the first gate electrode of an edge of the first semiconductor layer, and a part facing the second gate electrode of an edge of the second semiconductor layer, except for on the first channel region and the first and second contact parts.

### EFFECT OF THE INVENTION

According to the semiconductor device of the present invention, a high-performance and high-reliable semiconductor device including TFTs with different characteristics formed on the same substrate can be provided.

### BEST MODES FOR CARRYING OUT THE INVENTION

The present invention is mentioned in more detail below with reference to Embodiments using drawings, but not limited thereto.

### Embodiment 1

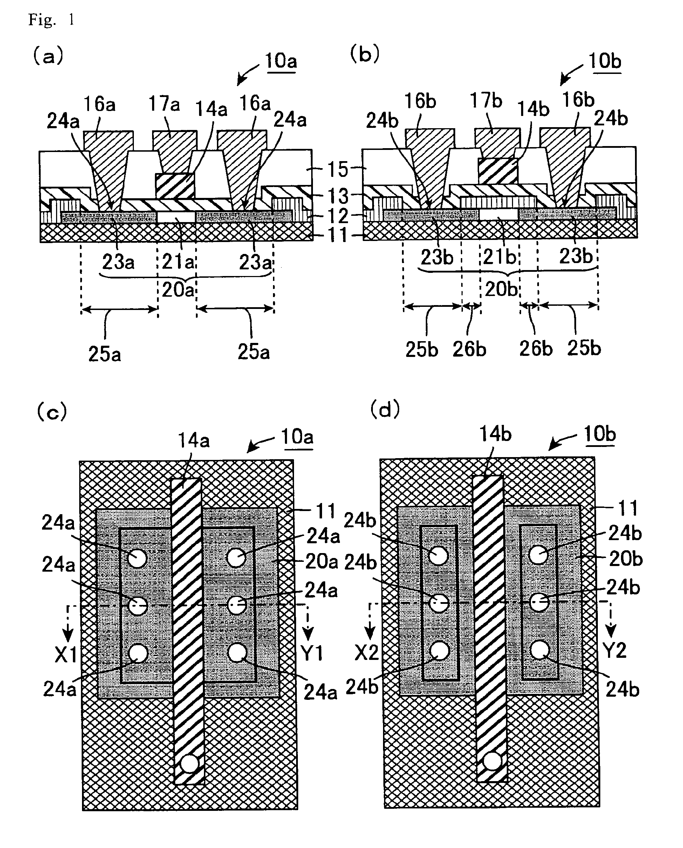

Fig. 1 is a schematic view showing a configuration of a semiconductor device in accordance with Embodiment 1. Fig. 1(a) is a cross-sectional view schematically showing a low voltage transistor taken along line X1-Y1 in Fig. 1(c). Fig. 1(b) is a cross-sectional view schematically showing a high voltage transistor taken along line X2-Y2 in Fig. 1(d). Fig. 1(c) is a plan view schematically showing the low voltage transistor. Fig. 1 (d) is a plan view schematically showing the high voltage transistor. The thick lines in Figs. 1(c) and 1(d) show a position of an edge of a first insulating film.

The semiconductor device in accordance with Embodiment 1 includes TFTs 10a and 10b on the same substrate 11, as shown in Fig. 1. The TFTs 10a and 10 b are planar (top-gate) TFTs and have a single drain structure.

The TFT 10a has a structure in which an island-shaped semiconductor layer 20a, a first insulating film 12, a second insulating film 13, and a gate electrode 14a are formed in this order from the substrate 11 side. Further, the TFT 11 further includes an inter layer insulating film 15 cover ing these members, and wirings 16a and 17a formed on the film 15.

Similarly to the TFT 10a, the TFT 10b has a structure in which an island-shaped semiconductor layer 20b, the first insulating film 12, the second insulating film 13, and a gate electrode 14b are formed in this order from the substrate 11 side. Further, the TFT further includes the interlayer insulating film 15 covering these members, and wirings 16b and 17b formed on the film 15.

Thus, the first insulating film 12, the second insulating film 13, and the interlayer insulating film 15 are common between the TFTs 10a and 10b. That is, the first insulating film 12, the second insulating film 13, and the interlayer insulating film 15, each constituting the TFT 10a, and those constituting the TFT 10b, are formed in the same step.

Components of the TFT 10a are mentioned, first. The semiconductor layer 20a includes a channel region 21a facing the gate electrode 14a and a source-drain region 23a that is a region other than the channel region 21a. That is, the source-drain region 23a is arranged adjacent to the channel region 21a in the channel length direction. The source-drain region 23a includes a contact part 24a that is contact with the wiring 16a.

In the present description, the source-drain region means regions that function as a source and/or drain of a transistor. If one functions as source, the other functions as drain.

The first insulating film 12 is not formed on the channel region 21a and the contact part 24a, in the TFT 10a. More specifically, in the TFT 10a, the first insulating film 12 is not formed on an inside region of the island-shaped semiconductor layer 20a including the channel region 21a and the contact part 24a, when the substrate 11 is viewed in plane, as shown in Fig. 1(c). The first insulating film 12 is formed to cover an edge of the semiconductor layer 20a in the TFT 10a.

In the TFT 10a, the second insulating film 13 is formed at least on the channel region 21a and the source-drain region 23a except for the contact part 24a. More preferably, in the TFT 10a, the second insulating film 13 is formed on the semiconductor layer 20a and the first insulating film 12, except for the contact part 24a.

The gate electrode 14a is formed to face the channel region 21a with the second insulating film 13 therebetween.
Accordingly, the second insulating film 13 functions as a gate insulating film in the TFT 10a.

The wiring 16a is connected to the source-drain region 23a through the contact hole formed in the interlayer insulating film 15. More specifically, the wiring 16a is connected to the source-drain region 23a by being in contact with the contact part 24a in the source-drain region 23a. The wiring 17a is connected to the gate electrode 14a through a contact hole formed in the interlayer insulating film 15.

Thus, in the TFT 10a, the gate insulating film is only composed of the second insulating film 13. Accordingly, the TFT 10a can be driven at high speed, and it is preferably used, for example, as a TFT (low voltage transistor) that is driven at a low voltage of 5V or less (for example, 2 to 5V). Specifically, the TFT 10a can be preferably used in a logical circuit. If the semiconductor device of the present Embodiment is used in a display device such as a liquid crystal display device, the TFT 10a can be preferably used in a shift resistor circuit, a source driver circuit, and the like.

Components of the TFT 10b are mentioned below. The semiconductor layer 20b has a channel region 21b facing the gate electrode 14b and a source-drain region 23b facing a region except for the channel region 21b. That is, the source-drain region 23b is arranged adjacent to the channel region 21b in the channel length direction. The source-drain region 23b includes a contact part 24b that is in contact with the wiring 16b.

In the TFT 10b, the first insulating film 12 is formed on the channel region 21a but not formed on the contact part 24b, as shown in Fig. 1(d). The first insulating film 12 is formed to over an edge of the semiconductor layer 20a in the TFT 10b. Further, the width in the channel length direction of the first insulating film 12 on the channel region 21b is set to be larger than the channel length by about 0.5 to 4 µm (preferably 1 to 2 µm).

In the TFT 10b, the second insulating film 13 is formed at least on the channel region 21b and the source-drain region 23a except for the contact part 24b. More preferably, in the TFT 10b, the second insulating film 13 is formed on the semiconductor layer 20b and the first insulating film 12, except for the contact part 24b.

The gate electrode 14b is formed to face the channel region 21b with the first insulating film 12 and the second insulating film 13 therebetween. Accordingly, in the TFT 10b, the first insulating film 12 and the second insulating film 13 function as a gate insulating film.

The wiring 16b is connected to the source-drain region 23b through a contact hole formed in the interlayer insulating film 15. More specifically, the wiring 16b is connected to the source-drain region 23b by being in contact with the contact part 24b of the source-drain region 23b. The wiring 17b is connected to the gate electrode 14b through a contact hole formed in the interlayer insulating film 15.

Thus, in the TFT 10b, the gate insulating film is a multi-layer film composed of the first insulating film 12 and the second insulating film 13. Accordingly, the TFT 10b is preferably used, for example, as a TFT (high voltage transistor) that is driven at a high voltage of 10V or more. Specifically, the TFT 10b is preferable as a transistor that functions like an analogue switch.

As mentioned above, according to the semiconductor device including the TFTs 10a and 10b of the present invention, the first insulating film 12 is formed on the channel region 21b, except for on the channel region 21a and the contact parts 24a and 24b. The second insulating film 13 is formed on the channel region 21a, a part facing the channel region 21b of the first insulating film 12, the source-drain region 23a except for the contact part 24a, and the source-drain region 23b except for the contact part 24b. Accordingly, the gate insulating film in the TFT 10a can be formed to have a single-layer structure, and the gate insulating film in the TFT 10b can be formed to have a multi-layer structure (two-layered structure). As a result, the semiconductor device of the present Embodiment can include the TFT 10a that exhibits excellent characteristics as a low voltage transistor and the TFT 10b that exhibits excellent characteristics as a high voltage transistor on the same substrate 11.

The width in the channel length direction of the first insulating film 12 on the channel region 21b can be appropriately determined as far as the film 12 does not overlap with the contact part 24b. That is, the first insulating film 12 can be provided with a margin taking into consideration of misalignment when the first insulating film 12 is patterned. Accordingly, according to the semiconductor device of the present Embodiment, for example, even if misalignment occurs when the first insulating film 12 is patterned, it is possible to suppress the gate insulating film to unevenly (partly) have a single structure in the TFT 10b. As a result, in the TFT 10b, a variation in threshold value can be suppressed. In the TFT 10a, the channel region 21a and the source-drain region 23a except for the contact part 24a are covered with only the second insulating film 13 that is a single layer, and so the TFT 10a is not influenced even if misalignment occurs when the first insulating film 12 is patterned. Thus, the semiconductor device of the present Embodiment can include the TFTs 10a and 10b excellent in reliability on the same substrate 11.

On the source-drain region 23a except for the contact part 24a and the source-drain region 23b except for the contact part 24b, the second insulating film 13 that is a single layer is arranged. When the source-drain regions 23a and 23b are doped with impurities, the second insulating film 13 is formed also on the contact parts 24a and 24b. Accordingly, the second insulating film 13 that is a single layer is formed on the source-drain regions 23a and 23b including the contact parts 24a and 24b, respectively, when the source-drain regions 23a and 23b are doped with impurities. Accordingly, the source-drain regions 23a and 23b can be doped with impurities, simultaneously, and an amount of high concentration impurities (N⁺ or P⁺) for the source-drain regions 23a and 23b can be easily optimized. As a result, contact resistances of the contact parts 24a and 24b can be reduced. That is, the TFTs 10a and 10b can include optimum impurity concentration regions 25a and 25b each of which is doped with impurities at an optimum concentration, respectively.

In the TFT 10b, the source-drain region 23b in a region that is positioned on the outside of the edge of the gate electrode 14b (channel region 21b) and where the first insulating film 12 and the second insulating film 13 are stacked has a smaller doping amount of impurities than that of the optimum impurity concentration region 25b. That is, this region is a low dose region 26b where the doping amount of impurities is lower than that of the optimum impurity concentration region 25b. Accordingly, in the TFT 10b, it is possible to effectively suppress generation of problems in resistance value, caused by excess doping.

The low dose region 26b has a lower doping amount of impurities than those of the optimum impurity concentration regions 25a and 25b, and so has a sheet resistance larger than those of the regions 25a and 25b. More specifically, the low dose region 26b has a resistance of about 1 to 2 kΩ/□. The regions 25a and 25b each have a resistance of about 0. 5 to 1 kΩ/□. That is, the low dose region 26b has a resistance value twice as larger as those of the regions 25a and 25b. However, the resistance value of the low dose region 26b is not large enough to have influences on an on-state current of transistor characteristics, and so the characteristics of the TFT 10b are not deteriorated.

In a conventional configuration, a dielectric breakdown is easily generated between the gate electrode and the semiconductor layer, near at the edge of the island-shaped semiconductor layer. This is because, at the edge of the semiconductor layer, the coating property of the gate insulating film is deteriorated, and its thickness is decreased. However, in the present Embodiment, the first insulating film 12 is formed to cover an edge of the semiconductor layer 20a and also cover an edge of the semiconductor layer 20b. So the edge of the semiconductor layer 20a in the region facing the gate electrode 14a is covered with two insulating layers, the first and second insulating films 12 and 13. Similarly, the edge of the semiconductor layer 20b in the region facing the gate electrode 14b is covered with two insulating layers, the first and second insulating films 12 and 13. Accordingly, in the TFTs 10a and 10b, the breakdown withstand voltage of the gate insulating film can be improved.

Conventionally, in an N-channel TFT formed through channel doping, an edge of a semiconductor layer has a thickness smaller than that of the center of a channel, and so a parasitic transistor at the edge of the semiconductor layer has a low threshold voltage.
In addition, also because the gate insulating film has a small thickness at the edge of the semiconductor layer, the threshold voltage of the parasitic transistor is low. As a result, there is a problem in that a leakage current is increased when a gate voltage is 0V. This problem is remarkably caused in a low voltage transistor that needs a low threshold voltage. The embodiment of the present invention provides a solution for this problem because the gate insulating film at the edge of the semiconductor layer has a large thickness.

The edge of the semiconductor layer where the gate insulating film has a small thickness tends to be easily influenced by plasma damage and static electricity and as a result, it tends to trap fixed electric charges in process of forming TFTs. As a result, the threshold value of the parasitic transistor at the edge of the semiconductor layer largely varies, which leads to an increase in leakage current and/or a variation in threshold voltage of TFTs, conventionally. The embodiment of the present invention also provides a solution for this problem because the gate insulating film at the edge of the semiconductor layer has a large thickness.

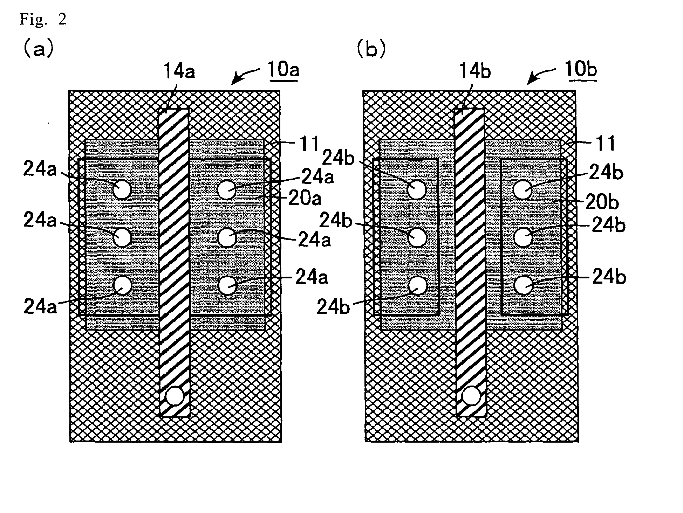

Fig. 2 is a schematic view showing a configuration of another semiconductor device in accordance with Embodiment 1.
Fig. 2 (a) is a schematic plan view of a low voltage transistor in a ccordance with the modified example. Fig. 2 (b) is a schematic plan view of a high voltage transistor in accordance with the modified example. The thick lines in Figs. 2 (a) and 2 (b) show positions of an edge of a first insulating film. In order to improve a breakdown withstand voltage of a gate insulating film, the first insulating film 12 is formed at least on a part facing the gate electrode 14a of an edge of the semiconductor layer 20a and a region facing the gate electrode 14b of an edge of the semiconductor layer 20b. Accordingly, if the source-drain regions 23a and 23b have an insufficient area, as shown in Figs. 2(a) and 2(b), the first insulating film 12 may be formed to cover an edge of the semiconductor layer 20a with which the gate electrode 14a is crossed and an edge of the semiconductor layer 20b with which the gate electrode 14b is crossed. Also in this embodiment, a sufficient breakdown withstand voltage of a gate insulating film can be obtained. If the source-drain regions auxiliarly 23a and 23b have sufficient large areas, it is preferable that the entire edge of the first insulating film 12 is arranged on the semiconductor layers 20a and 20b as shown in Figs. 1(c) and 1(d) in order to prevent generation of particles, caused by an etching remaining portion of a gate electrode and/or a residual photoresist, which tend(s) to be generated in a spot-facing formed at the edge of the semiconductor layer.

A modified example of the present Embodiment is mentioned below.

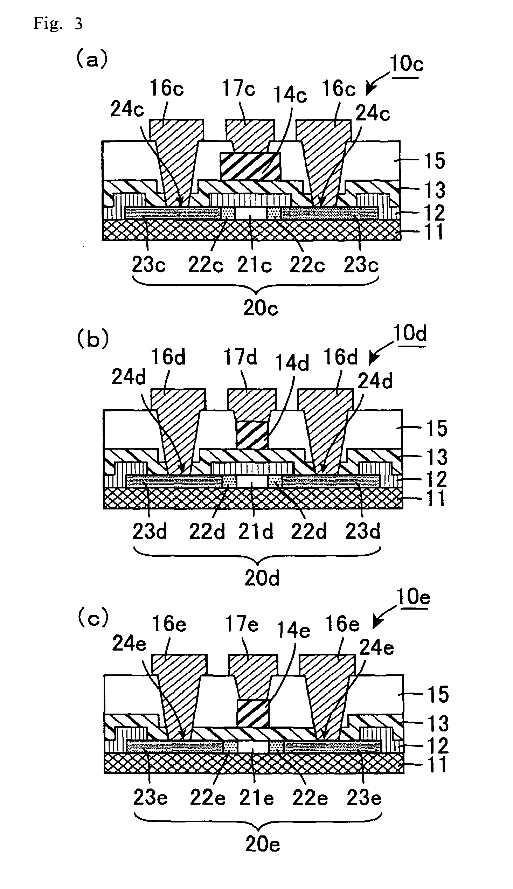

Fig. 3 is a cross-sectional view schematically showing a configuration of a semiconductor device in accordance with a modified example of Embodiment 1. Fig. 3 (a) is a high voltage transistor having a GOLD structure. Fig. 3(b) is a high voltage transistor having an LDD structure. Fig. 3 (c) is a low voltage transistor having an LDD structure.

The semiconductor device of the present Embodiment may have, on the same substrate 11, a TFT 10c having a GOLD (gate overlapped LDD) structure, a TFT 10d having an LDD structure, a TFT 10e having an LDD structure, as shown in Fig. 3.

The TFT 10c includes a semiconductor layer 20c having:
a channel region 21c; a low concentration impurity region 22c; and a source-drain region 23c. The channel region 21c is
positioned in a region facing a gate electrode 14c. The region 22c is positioned on the both outsides of the channel region 21c in the channel length direction. The source-drain region 23c is a region except for the channel region 21c and the region 22c. The region 22c is adjacent to the channel region 21c in the channel length direction. The source-drain region 23c is adjacent to the region 22c in the channel length region. The source-drain region 23c includes a contact part 24c that is in contact with the wiring 16c. The region 22c functions as an LDD region.

In the TFT 10c, the first insulating film 12 is formed on the channel region 21c and the low concentration impurity region 22c, except for on the contact part 24c. The first insulating film 12 is formed to cover the edge of the semiconductor layer 20c in the TFT 10c. Further, the width in the channel length direction of the first insulating film 12 on the channel region 21c and the low concentration impurity region 22c is set to be larger than the length of the channel region 21c and the region 22c in the channel length direction by about 0.5 to 4 µm (preferably 1 to 2 µm).

In the TFT 10c, the second insulating film 13 is formed at least on the channel region 21c, the low concentration impurity region 22c, and the source-drain region 23c except for the contact part 24c. More preferably, in the TFT 10c, the second insulating film 13 is formed on the semiconductor layer 20c and the first insulating film 12 except for the contact part 24c.

The gate electrode 14c is formed to face the channel region 21c and the low concentration impurity region 22c with the first and second insulating films 12 and 13 therebetween. Accordingly, in the TFT 10b, the first and second insulating films 12 and 13 function as a gate insulating film.

Similarly to the TFT 10a and the like, the TFT10c further includes the interlayer insulating film 15, a wiring 16c that is connected to the contact part 24c, and a wiring 17c that is connected to the gate electrode 14c.

Thus, the TFT 10c includes a gate insulating film that is a multi-layer film composed of the first and second insulating films 12 and 13. The TFT 10c has a GOLD structure. Accordingly, the TFT 10c is inferior to the TFT 10b in driving speed, but it has very excellent reliability and very high resistance to hot carrier deterioration, and further it can very effectively suppress a short-channel effect. The TFT 10c is preferably used as a high voltage transistor. Specifically, the TFT 10c can be preferably used in a circuit where a power voltage is high, for example, 8 to 16V (high voltage circuit). If the semiconductor device of the present Embodiment is used in a display device such as a liquid crystal display device, the TFT 10c can be preferably used in a gate driver and the like.

The TFT 10d includes a semiconductor layer 20d having a channel region 21d, a low concentration impurity region 22d, and a source-drain region 23d. The channel region 21d faces a gate electrode 14d. The low concentration impurity region 22d is positioned on the both outsides of the channel region 21d in the channel length direction. The source-drain region 23d is a region except for the channel region 21d and the region 22d. That is, the region 22d is adjacent to the channel region 21d in the channel length region. The source-drain region 23d is adjacent to the region 22d in the channel length direction. The source-drain region 23d includes a contact part 24d that is in contact with the wiring 16d. The region 22d functions as an LDD region.

In the TFT 10d, the first insulating film 12 is formed on the channel region 21d and the low concentration impurity region 22d, except for on the contact part 24d. The first insulating film 12 is formed to cover the edge of the semiconductor layer 20d in the TFT 10d. Further, the width in the channel length direction of the first insulating film 12 on the channel region 21d and the region 22d is set to be larger than the length of the channel region 21d in the channel length direction by about 0.5 to 4 µm (preferably 1 to 2 µm). The first insulating film 12 is set to be larger than the width in the channel length direction of the channel region 21d by 0.5 to 2 µm (preferably about 1 to 1.5 µm).

In the TFT 10d, the second insulating film 13 is formed at least on the channel region 21d, the low concentration impurity region 22d, and the source-drain region 23d except for the contact part 24d. More preferably, the second insulating film 13 is formed on the semiconductor layer 20d and the first insulating film 12 except for the contact part 24d.

The gate electrode 14d is formed to face the channel region 21d with the first and second insulating films 12 and 13 therebetween. Accordingly, in the TFT 10d, the first and second insulating films 12 and 13 function as a gate insulating film.

Similarly to the TFT 10a and the like, the TFT10d further includes the interlayer insulating film 15, a wiring 16d that is connected to the contact part 24d, and a wiring 17d that is connected to the gate electrode 14d.

Thus, the TFT 10d includes a gate insulating film that is a multi-layer film composed of the first and second insulating films 12 and 13. The TFT 10d has a LDD structure. Accordingly, the TFT 10d is inferior to the TFT 10b in driving speed, but it has very excellent reliability and very high resistance to hot carrier deterioration, and further it can very effectively suppress a short-channel effect. The TFT 10d is preferably used as a high voltage transistor. Specifically, the TFT 10c can be preferably used in a pixel switching transistor, and the like, if the semiconductor device of the present Embodiment is used in a display device such as a liquid crystal display device.

The TFT 10e includes a semiconductor layer 20e having a channel region 21e, a low concentration impurity region 22e, and a source-drain region 23e. The channel region 21e faces a gate electrode 14e. The low concentration impurity region 22e is positioned on the both outsides of the channel region 21e in the channel length direction. The source-drain region 23e is a region except for the channel region 21e and the region 22e. That is, the region 22e is adjacent to the channel region 21e in the channel length region. The source-drain region 23e is adjacent to the region 22e in the channel length direction. The source-drain region 23e includes a contact part 24e that is in contact with the wiring 16e. The region 22e functions as an LDD region.

In the TFT 10e, the first insulating film 12 is not formed on the channel region 21e, the low concentration impurity region 22e, and the contact part 24e. More specifically, in the TFT 10e, the first insulating film 12 is not formed on an inside region of the island-shaped semiconductor layer 20e including the channel region 21e, the low concentration impurity region 22e, and the contact part 24e, when the substrate 11 is viewed in plane. The first insulating film 12 is formed to cover the edge of the semiconductor layer 20e in the TFT 10e. ,

In the TFT 10e, the second insulating film 13 is formed at least on the channel region 21e, the low concentration impurity region 22e, and the source-drain region 23e except for the contact part 24e. More preferably, in the TFT 10e, the second insulating film 13 is formed on the semiconductor layer 20e and the first insulating film 12, except for the contact part 24e.

The gate electrode 14e is formed to face the channel region 21e with the second insulating film 13 therebetween. Accordingly, the second insulating film 13 functions as a gate insulating film in the TFT 10e.

Similarly to the TFT 10a and the like, the TFT10e further includes the interlayer insulating film 15, a wiring 16e that is connected to the contact part 24e, and a wiring 17e that is connected to the gate electrode 14e.

Thus, in the TFT 10e includes a gate insulating film that is only composed of the second insulating film 13. Further, the TFT 10d has an LDD structure. Accordingly, the TFT 10d is inferior to the TFT 10a in driving speed, but superior to the TFT 10b and the like in it. In addition, the TFT 10e has excellent reliability and high resistance to hot carrier deterioration, and further it can effectively suppress a short-channel effect. Further, the TFT 10e is preferably used as a low voltage transistor. Specifically, the TFT 10e can be preferably used, for example, in a circuit where a power voltage is slightly higher than that in a circuit where the TFT 10a is used. For example, the TFT 10a is preferably used in a circuit where a power voltage is 5V or less. The TFT 10e is preferably used in a circuit where a power voltage is 4 to 8V (more preferably 6 to 8V).

As mentioned above, according to the semiconductor device including the TFTs 10c, 10d, and 10e of the present Embodiment, the first insulating film 12 is formed on the channel region 21c, the low concentration impurity region 22c, the channel region 21d, and the low concentration impurity region 22d, except for on the channel region 21e and the contact parts 24c, 24d, and 24e. The second insulating film 13 is formed on the channel region 21e; the low concentration impurity region 22e; the part facing the channel region 21c and the low concentration impurity region 22c of the first insulating film 12; the part facing the channel region 21d and the low concentration impurity region 22d of the first insulating film 12; the source-drain region 23c except for the contact part 24c; the source-drain region 23d except for the contact part 24d; and the source-drain region 23e except for the contact part 24e. As a result, the semiconductor device of the present Embodiment can include the TFTs 10c and 10d each having excellent characteristics as a high voltage transistor and the TFT 10e that exhibits excellent characteristics as a low voltage transistor on the same substrate 11.

The width in the channel length direction of the first insulating film 12 on the channel region 21c and the region 22c can be appropriately determined as far as the film 12 does not overlap with the contact part 24c. As a result, similarly to the TFT 10b, a variation in threshold value can be suppressed in the TFT 10c.

The width in the channel length direction of the first insulating film 12 on the channel region 21d and the region 22d can be appropriately determined as far as the film does not overlap with the contact part 24d. As a result, similarly to the TFT 10b, a variation in threshold value can be suppressed in the TFT 10d.

In the TFT 10e, the channel region 21e, the low concentration impurity region 22e, and the source-drain region 23e except for the contact part 24e are covered with only the second insulating film 13 that is a single layer, and so the TFT 10e is not influenced even if misalignment occurs when the first insulating film 12 is patterned. Thus, the semiconductor device of the present Embodiment can include the TFTs 10c, 10d, and 10e excellent in reliability on the same substrate 11.

On the source-drain region 23c except for the contact part 24c, the source-drain region 23d except for the contact part 24d, and the source-drain region 23e except for the contact part 24e, the second insulating film 13 that is a single layer is arranged. Accordingly, similarly to the TFT 10a and 10b, when the source-drain regions 23c, 23d, and 23e are doped with impurities, an amount of the impurities are optimized. As a result, contact resistances of the contact parts 24c, 24d, and 24e can be reduced.

Similarly to the TFT 10b, it is possible to effectively suppress resistance defects caused by excess doping.

The first insulating film 12 is formed to cover edges of the semiconductor layers 20c, 20d, and 20e. Accordingly, in the TFTs 10c, 10d, and 10e as well as the TFTs 10a and 10b, the breakdown withstand voltage of the gate insulating film can be improved.

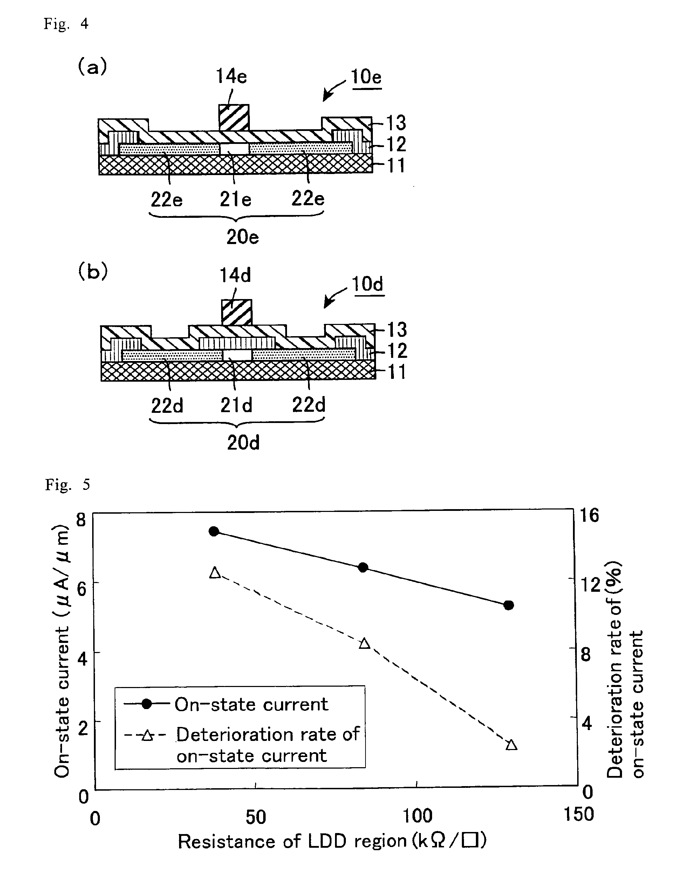

The TFTs 10d and 10e having an LDD structure are mentioned in more detail below. Fig. 4 is a cross-sectional view schematically showing a configuration of the semiconductor device in accordance with the modified example of Embodiment 1 during production processes. Fig. 4 (a) shows a low voltage transistor having an LDD structure. Fig. 5(b) shows a high voltage transistor having an LDD structure.

As shown in Fig. 4, after the gate electrodes 14d and 14e are formed, doping of low concentration impurity is performed to form low concentration impurity regions 22d and 22e that function as an LDD region. In the TFT 10e, a semiconductor 20e is doped with impurities through the second insulating film 13. In the TFT 10d, a region where the low concentration impurity region 22d is to be formed of the semiconductor layer 20d is doped with impurities through the first and second insulating films 12 and 13. Accordingly, the low concentration impurity region 22e of the TFT 10e is doped with the impurities at a relatively high concentration, and the low concentration impurity region 22d of the TFT 10d is doped with the impurities at a relatively low concentration. As a result, the sheet resistance of the region 22e of the TFT 10e, which is preferably used as a low voltage transistor, can be set to be 20 to 50 kΩ/□, and the sheet resistance of the region 22d of the TFT 10d, which is preferably used as a high voltage transistor, can be set to be 40 to 150k kΩ/□.

The sheet resistance is measured by two- or four-terminal resistance evaluation pattern (TEG).

The low voltage transistor is typically driven at a low voltage, and so not high reliability but high current driving force is needed for it. In this case, it is preferable that the resistance of the LDD region is set to be a low value. For the high current driving, a single drain structure is preferable. However, the single drain structure is insufficient in reliability for hot carrier deterioration. For example, a transistor having a single drain structure with a channel length of 4 µm can not secure reliability at 6V or more. In addition, according to the single drain structure, the short-channel effect is easily exhibited, and so it is difficult to set a threshold voltage to a small value. In contrast, according to the LDD structure, the resistance for the hot carrier deterioration is high and the short-channel effect can be suppressed, compared with the single drain structure. Thus, in the TFT10e, the current driving force can be relatively large, and also the reliability can be secured at a medium voltage, for example, if a power voltage is 4 to 8V (more preferably 6 to 8V).

The high voltage transistor is driven at a high voltage, and so high reliability is needed for it. Deterioration caused by an electrical field that is generated in the direction vertically to the substrate plane (electrical field due to a gate voltage) can be suppressed by increasing the thickness of the gate insulating film. That is, the gate insulating film has a multi-layer structure, and thereby, the reliability can be improved. Deterioration caused by an electrical field that is generated in the direction parallel to the substrate plane (lateral direction) (electrical field due to a drain voltage) can be suppressed by increasing a resistance of the LDD region. As a result, the resistance to hot carrier deterioration can be improved.

For a pixel switching transistor that is used as a switching element of a display device such as a liquid crystal display device, suppression of a leakage current is needed. As such a pixel switching transistor, the TFT 10d having an LDD region with a high resistance is used, and thereby a leakage current can be suppressed.

Thus, various transistors each having a single drain, GOLD, or LDD structure are employed according to their requirements. As a result, a high performance and high reliable circuit can be formed.

Fig. 5 is a graph showing a relationship between a resistance of an LDD region of a TFT having an LDD structure, and an on-state current (current driving force) and a hot carrier deterioration rate (deterioration rate of on-state current). As shown in the graph, according to the LDD structure, an increase in resistance of the LDD region decreases the rate of hot carrier deterioration.

According to the GOLD structure, the resistance of the LDD region, where the hot carrier deterioration rate is the minimum value, is shown, and the GOLD structure has very high deterioration resistance. Compared with the LDD structure, the GOLD structure has a high current driving force, but has a high load capacitance, which increases an electrical power consumption.

The LDD structure has a low resistance to hot carrier deterioration and a low current driving force, compared with the GOLD structure. However, the LDD structure has low load capacitance compared with the GOLD structure, and therefore, it is advantageously used in a circuit that needs a reduction in electrical power consumption. The LDD structure can suppress generation of a leakage current, and so it is preferably applied to a circuit which needs to hold an output voltage. In a conventional TFT having an LDD structure, the resistance of the LDD region needs to be increased for increasing the resistance for hot carrier deterioration. However, in such a conventional TFT having an LDD structure, the current driving force is reduced as the resistance of the LDD region is increased. So it is very difficult to improve the hot carrier deterioration and current driving force by one kind of transistor.

In a low voltage transistor driven at a low voltage of about several volts, the resistance to hot carrier deterioration is not so important, and the current driving force for driving a circuit at a high speed is needed. In a high voltage transistor driven at a high voltage of 10 V or more, high-speed driving of high frequency is not performed from a viewpoint of suppressing electrical power consumption, and so the current driving force is not important and the resistance to hot carrier deterioration is important. Accordingly, if a transistor having an LDD structure with a low-resistant LDD region is formed as a low voltage transistor and a transistor having an LDD structure with a high-resistant LDD region is formed as a high voltage transistor, an optimum circuit can be formed.

According to the TFTs 10d and 10e of the present Embodiment, as mentioned above, the two transistors, i.e., a low voltage transistor with a relatively low-resistant LDD region, which is doped with impurities at a relatively high concentration, and a high voltage transistor with a relatively high-resistant LDD region, which is doped with impurities at a relatively low concentration, are simultaneously formed by performing the doping once without photolithography.

According to the present Embodiment, a mask LDD structure formed by photolithography is mainly described below, but the LDD structure may be one with a side wall, or a self-alignment LDD structure formed by doping a source-drain region with impurities at a high concentration to form a high concentration impurity region of a source-drain region, and decreasing the width of a gate electrode.

A production method of the semiconductor device of the present Embodiment is mentioned below.

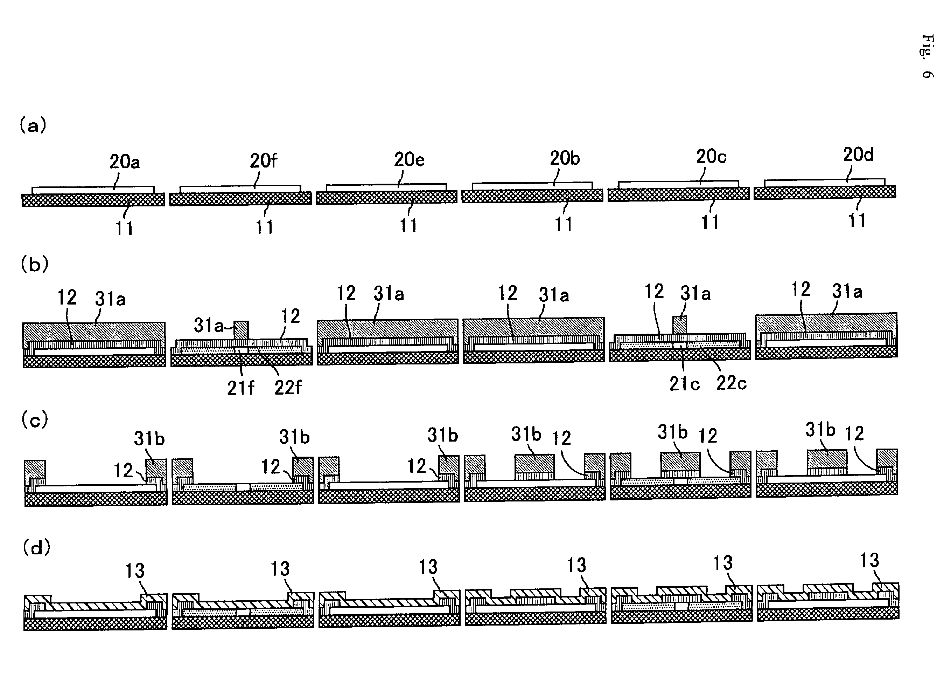

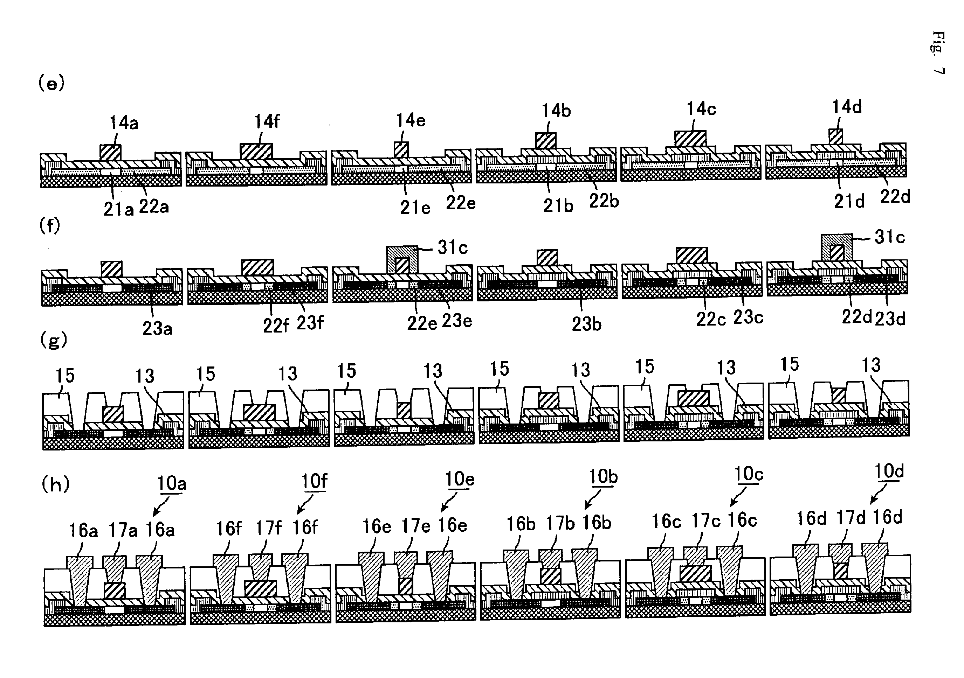

Figs. 6 (a) to 6 (d) and 7(e) and 7(h) are cross-sectional views schematically showing a configuration of the semiconductor device in accordance with Embodiment 1 during production steps.

As shown in Fig. 7(h), a semiconductor device having a TFT 10f in addition to the above-mentioned TFTs 10a to 10e on the same substrate 11 is mentioned. The case where the respective TFTs 10a to 10f are N-channel TFTs is mainly mentioned.

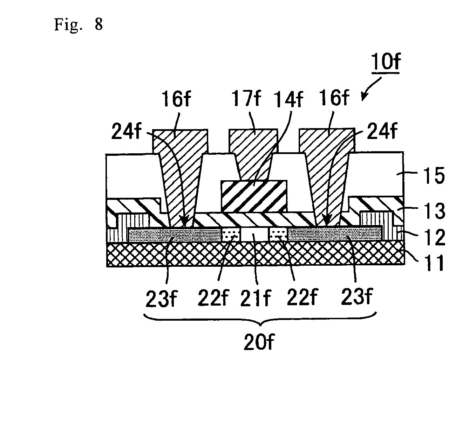

The configuration of the TFT 10f is mentioned first. Fig. 8 is a cross-sectional view schematically showing a configuration of a semiconductor device in accordance with a modified example of Embodiment 1 and shows a low voltage transistor with a GOLD structure. As shown in Fig. 8, the TFT 10f includes a semiconductor layer 20f having a channel region 21f, a low concentration impurity region 22f, and a source-drain region 23f. The channel region 21f is positioned in a region facing a gate electrode 14f. The low concentration impurity region 22f is positioned on the both outsides of the channel region 21f in the channel length direction. The source-drain region 23f is a region except for the channel region 21f and the region 22f. That is, the region 22f is adjacent to the channel region 21f in the channel length direction. The source-drain region 23f is adj acent to the region 22f in the channel length direction. The source-drain region 23f includes a contact part 24f that is in contact with the wiring 16f. The low concentration impurity region 22f functions as an LDD region.

In the TFT 10f, the first insulating film 12 is not formed on the channel region 21f, the low concentration impurity region 22f, and the contact part 24f. More specifically, in the TFT 10f, the first insulating film 12 is not formed on an inside region of the island-shaped semiconductor layer 20f including the channel region 21f, the region 22f, and the contact part 24f, when the substrate 11 is viewed in plane. The first insulating film 12 is formed to cover an edge of the semiconductor layer 20f in the TFT 10f.

In the TFT 10f, the second insulating film 13 is formed at least on the channel region 21f, the low concentration impurity region 22f and the source-drain region 23f except for the contact part 24f. More preferably, in the TFT 10f, the second insulating film 13 is formed on the semiconductor layer 20f and the first insulating film 12, except for the contact part 24f.

The gate electrode 14f is formed to face the channel region 21f and the low concentration impurity region 22f with the second insulating film 13 therebetween. Accordingly, the second insulating film 13 functions as a gate insulating film in the TFT 10f.

Similarly to the TFT 10a and the like, the TFT 10f further includes the interlayer insulating film 15, the wiring 16f that is connected to the contact part 24f, and a wiring 17f that is connected to the gate electrode 14f.

Thus, the TFT 10f includes a gate insulating film composed of only the second insulating film 13. The TFT 10f has a GOLD structure. Accordingly, the TFT 10f is inferior to the TFT 10a in driving speed, but has very excellent reliability and very high resistance to hot carrier deterioration, and further it can very effectively suppress a short-channel effect. The TFT 10f is preferably used as a low voltage transistor. Specifically, the TFT 10f can be preferably used, for example, in a switching circuit. The switching circuit needs a current driving force, and further a single drain structure cannot secure sufficient reliability if, in the switching circuit, an inverse voltage is applied between gate and source, i.e., if a negative bias is applied in an N-channel TFT and a positive bias is applied to a P-channel TFT. So the TFT 10f with high current driving force and reliability can be preferably used.

Then a production method of the semiconductor device including the TFTs 10a to 10f on the same substrate 11 of the present Embodiment is mentioned below.

As shown in Fig. 6(a), island-shaped semiconductor layers (active layers) 20a, 20b, 20c, 20d, 20e, and 20f with a thickness of 30 to 100 nm (preferably 40 to 50 nm) are formed on a main surface of the substrate 11. More specifically, the respective semiconductor layers 20a to 20f are formed as follows: an amorphous semiconductor film having an amorphous structure is formed by sputtering, LPCVD (low pressure CVD), or plasma CVD, the film is crystallized by laser, and the crystalline semiconductor film is patterned into a desired shape by photolithography. The material for the semiconductor layers 20a to 20f is not especially limited, and preferably silicon, a silicon germanium (SiGe) alloy, and the like, are used.

For crystallizing the semiconductor layers 20a to 20f, solid-phase growth may be employed. Specifically, a catalyst metal such as nickel (Ni) is applied on the amorphous semiconductor film, and then the film is subjected to a heat treatment by laser and the like. As a result, a CG (continuous grain) silicon film can be formed.

The crystallization by laser may be performed as follows: the film is irradiated with laser only once in atmospheric air containing about 20% of oxygen; or the film is irradiated with laser in atmospheric air and irradiated again in nitrogen atmosphere. According to the latter method, the surfaces of the semiconductor layers 20a to 20f can become more flat.

The material for the substrate 11 is not especially limited. A glass, quartz, or silicon substrate, a substrate having a metal or stainless surface on which an insulating film is formed, a heat-resistant plastic substrate that can withstand treatment temperatures, and the like, may be used as the substrate 11. A glass substrate is particularly preferable. A substrate that is used in a display device such as a liquid crystal display device is preferable as the substrate 11. Thus, the semiconductor device of the present Embodiment is preferable as a semiconductor device a display device includes, and particularly preferable as a semiconductor device that is arranged in a display device substrate.

A base layer may be formed between the substrate 11, and the respective semiconductor layers 20a to 20f. As the base layer, a silicon-containing insulating film (for example, SiO₂, SiN, SiNO), and the like, may be used. The base layer may have a multi-layer structure of two or more insulating films, in addition to a single insulating film structure. As a result, if a glass substrate is used as the substrate 11, the base layer makes it possible to suppress impurities such as an alkali metal element from diffusing from the substrate 11 and to reduce a variation in electrical characteristics among the TFTs 10a to 10f.

The first insulating film 12 is formed to have a thickness of 10 to 70 nm (preferably 30 to 50 nm). A silicon-containing insulating film (for example, a SiO₂ film, a SiN film, a SiNO film) that is formed by plasma CVD or sputtering can be used as the first insulating film 12. A SiO₂ film is particularly preferable as the first insulating film 12. The first insulating film 12 may have a multi-layer structure of two or more insulating films that are formed from different insulating materials, in addition to a single insulating film structure. In this case, it is preferable that a layer adjacent to the respective semiconductor layers 20a to 20f is a SiO₂ film. Thus, due to alternate layers of the semiconductor layers 20a to 20f and the SiO₂ films, if the semiconductor layers 20a to 20f are silicon layers, an interface state between the first gate insulating film 12 and each of the semiconductor layers 20a to 20f can be reduced. As a result, electrical characteristics of the TFTs 10a to 10f can be improved.

For the purpose of controlling threshold voltages of the TFTs 10a to 10f, ions of an impurity element such as boron (B) ions are implanted into the entire semiconductor layers 20a to 20f (channel doping). The semiconductor layers 20a and 20f are doped with boron ions at 50kV and 5 x 10¹² to 3 x 10¹³ cm⁻², regardless of a P-channel TFT or an N-channel TFT, and then, while the semiconductor layer that is to constitute a P-channel TFT is covered with a resist as a mask, the semiconductor layer that is to constitute an N-channel TFT is doped with boron ions at 50kV and 5 x 10¹² to 3 x 10¹³ cm⁻². The concentration of the impurity elements is about 2 x 10¹⁶ to 2 x 10¹⁷ cm⁻³ for the semiconductor layers of an N-channel TFT and it is about 1 x 10¹⁶ to 1 x 10¹⁷ cm⁻³ for the semiconductor layers of a P-channel TFT.

If a P-channel TFT is formed as any of the TFTs 10a to 10f, the above-mentioned channel doping is performed for only the semiconductor layers of N-channel TFTs or for both of the semiconductor layers of N-channel and P-channel TFTs may be subjected to it. In order to adjust threshold voltages of the respective semiconductor layers 20a to 20f to desired values, the semiconductor layers 20a to 20f are separately doped with impurities, appropriately, and thereby making a difference in impurity element concentration among the semiconductor layers 20a to 20f. The above-mentioned channel doping may be performed after the second insulating film 13 is formed. This allows a difference in threshold value between the TFTs 10a, 10e, and 10f suitable as a low voltage transistor, and the TFTs 10b, 10c, and 10d suitable as a high voltage transistor. It is preferable that the channel doping is performed after the first insulating film 12 is formed and before the first insulating film 12 is patterned from a viewpoint of unifying the impurity concentration among the channel regions and performing the channel doping under optimum conditions, in both of the TFTs 10a, 10e, and 10f suitable asalowvoltagetransistor, and the TFTs 10b, 10c, and 10d suitable as a high voltage transistor.

As shown in Fig. 6(b), while regions that are to constitute channel regions of the TFTs 10c and 10f and semiconductor layers 20a, 20b, 20d, and 20e of the TFTs except for the TFTs 10c and 10f are covered with a resist 31 as a mask, ions of impurity elements such as phosphorus (P) ions are implanted into regions that are to constitute the low concentration impurity region 22c and the source-drain region 23c of the TFT 10c and into regions that are to constitute the low concentration impurity region 22f and the source-drain region 23f of the TFT 10f at 50kV and 2 x 10¹³ to 5 x 10¹³ cm⁻² (low concentration doping for GOLD structure). The concentration of the impurity element is about 5 x 10¹⁷ to 5 x 10¹⁸ cm⁻³ in regions that are to constitute the low concentration impurity region 22c and the source-drain region 23c of the semiconductor layer 20c and in regions that are to constitute the low concentration impurity region 22f and the source-drain region 23f of the semiconductor layer 20f. As a result, the low concentration impurity regions 22c and 22f that are function as an LDD region in the TFTs 10c and 10f each having a GOLD structure are formed. Then the resist 31a is removed. Thus, the low concentration doping for GOLD structure and the below-mentioned low concentration doping for LDD structure are performed separately, and thereby the low concentration impurity regions 22c and 22f can be adjusted to have optimum impurity concentrations, respectively.

The low concentration doping for GOLD structure may be performed after the second insulating film is formed. As a result, the resistance value of the LDD region (the low concentration impurity region 22c) of the TFT 10c having a GOLD structure and the resistance value of the LDD region (the low concentration impurity region 22f) of the TFT 10f having a GOLD structure can be different.

As shown in Fig. 6(c), the resist 31b is formed into a pattern and then etched, thereby patterning the first insulating film 12. As a result, in the TFTs 10a, 10e, and 10f, the first insulating film 12 in the region overlapping with the edges of the semiconductor layers 20a, 20e, and 20f remains and the first insulating film 12 in the regions that are to constitute the channel regions 21a, 21e, and 21f, the source-drain regions 23a, 23e, and 23f, and the low concentration impurity regions 22e and 22f, is removed. In the TFTs 10b, 10c, and 10d, the first insulating film 12 in the region overlapping with the edges of the semiconductor layers 20b, 20c, and 20d and the first insulating film 12 in the regions that are to constitute the channel regions 21b, 21c, and 21d, and the low concentration impurity regions 22c and 22d, remains and the first insulating film 12 in the regions that are to constitute the contact parts 24b, 24c, and 24d of the source-drain regions 23b, 23c, and 23d, is removed. In consideration of the case where misalignment of a photomask and/or a variation in pattern size occur (s) when the resist 31b is patterned by photolithography, the first insulating film 12 is patterned so that the edged of the first insulating film 12 that overlaps with the edges of the semiconductor layers 20a to 20f is positioned on the inside of the edges of the semiconductor layers 20a to 20f with a distance 0 to 2 µm (preferably 0.5 to 1 µm) therefrom; and that the edge of the first insulating film 12 on the channel region 21b is positioned on the outside of the edge of the gate electrode 14b (i.e., the channel region 21b) with a distance of 0 to 2 µm (preferably 0.5 to 1 µm) therefrom. The first insulating film 12 may be formed to be positioned on the outside of the edge of the gate electrode with a distance of 0 to 2 µm (preferably 0.5 to 1 µm) therefrom in a single drain or GOLD structure. The first insulating film 12 may be formed to be positioned on the outside of the edge of the gate electrode with a distance of 0.5 to 2 µm (preferably 1 to 1. 5 µm) therefrom in an LDD structure. Then the resist 31b is removed.

The first insulating film 12 in the region overlapping with the edges of the semiconductor layers 20a to 20f may overlap with only the edges of the semiconductor layers 20a to 20f in the channel width directions, as shown in Fig. 2.

As shown in Fig. 6(d), the second insulating film 13 is formed over the entire of the substrate 11 to have a thickness of 10 to 70 nm (preferably 30 to 50 nm). A silicon-containing insulating film (for example, a SiO₂ film, a SiN film, a SiNO film) formed by plasma CVD or sputtering can be used as the second insulating film 13. A SiO₂ film is particularly preferable as the second insulating film 13. The second insulating film 13 may have a multi-layer structure of two or more insulating films, in addition to a single insulating film structure. In this case, it is preferable that a layer adjacent to the respective semiconductor layers 20a to 20f is a SiO₂ film. Thus, due to alternate layers of the semiconductor layers 20a to 20f and the SiO₂ films, electrical characteristics of the TFTs 10a to 10f can be improved, similarly to the first insulating film 12.

Then, a conductive film is formed by sputtering to have a thickness of 200 to 600 nm (preferably 300 to 400 nm), and then by photolithography, the conductive film is patterned into a desired shape, and thereby forming the gate electrodes 14a, 14b, 14c, 14d, 14e, and 14f, as shown in Fig. 7(e). The gate electrode 14a is formed to face a region that is to constitute the channel region 21a. The gate electrode 14b is formed to face a region that is to constitute the channel region 21b. The gate electrode 14c is formed to face a region that is to constitute the channel region 21c. The gate electrode 14d is formed to face a region that is to constitute the channel region 21d. The gate electrode 14e is formed to face a region that is to constitute the channel region 21e. The gate electrode 14f is formed to face a region that is to constitute the channel region 21f. Preferable examples of the material for the gate electrodes 14a to 14f include high melting point metals such as tantalum (Ta), tungsten (W), titanium (Ti), and molybdenum (Mo), and alloys or compounds, containing these high melting point metals as a main component. Nitrides are preferable as the compound containing a high melting point metal as a main component. The gate electrodes 14a to 14f may have a structure in which conductive films formed from these materials are stacked.

Then using the gate electrodes 14a to 14f as a mask, ions of an impurity element such as phosphorus (P) ions are implanted into the semiconductor layers 20a to 20f in a self-alignment manner at 70 kV and 1 x 10¹³ to 3 x 10¹³ cm⁻² (low concentration doping for LDD structure). The concentration of the impurity element is about 1 x 10¹⁷ to 1 x 10¹⁸ cm⁻³ in a region that is to constitute the source-drain region 23a, a region that is to constitute the source-drain region 23b, a region that is to constitute the source-drain region 23c, a region that is to constitute the source-drain region 23d, a region that is to constitute the source-drain region 23e, and a region that is to constitute the source-drain region 23f. As a result, the low concentration impurity regions 22d and 22e that function as an LDD region of the TFTs 10d and 10e having an LDD structure are formed.

As shown in Fig. 7(f), while the semiconductor layers 20d and 20e in a region that is to constitute an LDD region of the TFTs 10d and 10e are covered with a resist 31c, ions of an impurity element such as phosphorus (P) ions are implanted into the semiconductor layers 20a to 20f at 40 kV and 5 x 10¹⁵ to 1 x 10¹⁶ cm⁻² (high concentration doping for source-drain). The concentration of the impurity element is about 1 x 10¹⁹ to 1 x 10²⁰ cm⁻³ in a region that is to constitute the source-drain region 23a, a region that is to constitute the source-drain region 23b, a region that is to constitute the source-drain region 23c, a region that is to constitute the source-drain region 23d, a region that is to constitute the source-drain region 23e, and a region that is to constitute the source-drain region 23f. As a result, the low concentration impurity regions 22c, 22d, 22e, and 22f that function as an LDD region are formed. The high concentration impurity regions 23a, 23b, 23c, 23d, 23e, and 23f that function as a source-drain region are also formed. In the TFTs 10b, 10c, and 10d, the region that is doped with the impurities through the first and second insulating films 12 and 13 are low dose regions where the doping amount of the impurities is small, as mentioned above. The resistance value of this low dose region is smaller than the resistance value of the low concentration impurity region 22c or 22d that functions as an LDD region. So this low dose region has no influences on current driving force of the TFTs 10b, 10c, and 10d.

If a P-channel TFT is formed as any of the TFTs 10a to 10f, the following steps may be performed: while the semiconductor layer of a P-channel TFT is covered with a mask, a region that is to constitute a source-drain region of the semiconductor layer of a N-channel TFT is doped with impurities at a high concentration; while the semiconductor layer of the N-channel TFT is covered with a mask, a region that is to constitute a source-drain region of the P-channel TFT is doped with impurities at a high concentration.

Although the source-drain regions 23a to 23f are doped only with unipolar impurities, if a CG silicon film is formed as the semiconductor layers 20a to 20f, for gettering of the catalyst metal such as Ni, edges of the semiconductor layers 20a to 20f or a region that has no influences on TFT characteristics except for the contact parts 24a to 24f of the semiconductor layers 20a to 20f, may be doped with an impurity with reverse polarity.

Then the interlayer insulating film 15 is formed over the entire substrate 11 to have a thickness of 0.5 to 1.5 µm (preferably 0.7 to 1.0 µm). A silicon-containing insulating film (for example, a SiO₂ film, a SiN film, a SiNO film) formed by plasma CVD or sputtering can be used as the interlayer insulating film 15. The interlayer insulating film 15 may have a multi-layer structure of two or more insulating layers, in addition to a single insulating film structure. The interlayer insulating film 15 is particularly preferably a multi-layer film composed of a hydrogen-containing silicon nitride (SiN:H) film with a thickness of 0.2 to 0.4 µm and a SiO₂ film with a thickness of 0.4 to 0.6 µm stacked from the substrate 11 side. Then the entire substrate 11 is heated at 400°C to 450°C for about 0.5 to 1 hour, thereby hydrogenating and activating the semiconductor layers 20a to 20f. The hydrogen contained in the silicon nitride film is diffused into the semiconductor layers 20a to 20f to terminate a dangling bond in each of the semiconductor layers 20a to 20f. Thus, the use of the hydrogen-containing silicon nitride film permits effective hydrogenation of the semiconductor layers 20a to 20f. By photolithography, the interlayer insulating film 15 and the second insulating film 13 are provided with contact holes corresponding to the source-drain regions 23a to 23f and the gate electrodes 14a to 14f.

The step of hydrogenating and activating the semiconductor layers 20a to 20f may be performed after the contact hole is formed.

Finally, a conductive film is formed by sputtering to have a thickness of 400 to 1000 nm (preferably 600 to 800 nm) and the film is patterned into a desired shape by photolithography. As shown in Fig. 7(h), the wirings 16a, 17a, 16b, 17b, 16c, 17c, 16d, 17d, 16e, 17e, 16f, and 17f are formed. As a result, the semiconductor device of the present Embodiment can be completed. Preferable examples of the material for the wirings 16a, 17a, 16b, 17b, 16c, 17c, 16d, 17d, 16e, 17e, 16f, and 17f include low resistant metals such as aluminum (Al), copper (Cu), and silver (Ag), and alloys or compounds, containing these low resistant metals as a main component. These wirings 16a, 17a, 16b, 17b, 16c, 17c, 16d, 17d, 16e, 17e, 16f, and 17f may have a structure in which conductive films formed from these materials are stacked.

If necessary, amulti-layer wiring structuremaybe formed, or a protective film that is a resin film and/or a silicon nitride film may be formed after the wirings 16a, 17a, 16b, 17b, 16c, 17c, 16d, 17d, 16e, 17e, 16f, and 17f are formed.

As mentioned above, according to the production method of the semiconductor device of the present Embodiment, a semiconductor device including the TFTs 10a to 10f excellent in performances and reliability on the same substrate 11 can be produced.

Another production method of the semiconductor device of the present Embodiment is mentioned below.

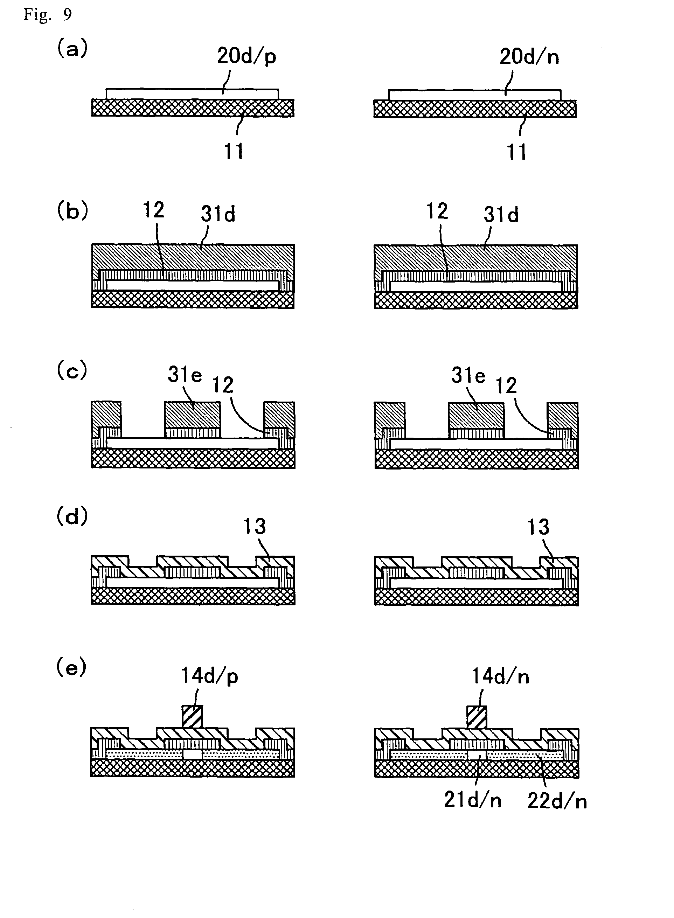

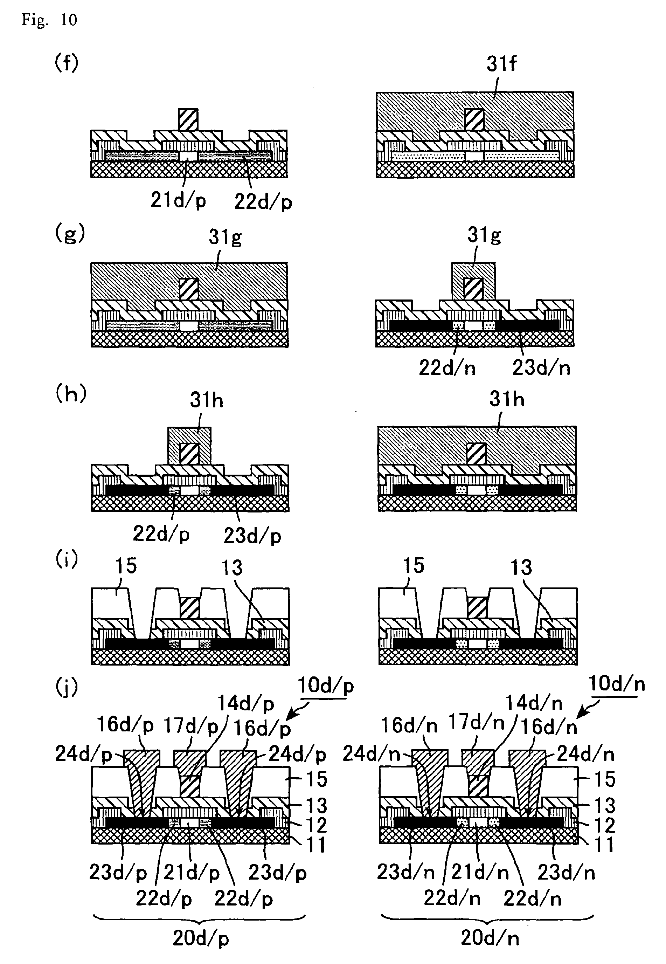

Figs. 9(a) to 9(e) and 10(f) to 10(j) are cross-sectional views each schematically showing a configuration of the semiconductor device in accordance with a modified example of Embodiment 1 during production steps.

As shown in Fig. 10(j), a TFT 10d/n and a TFT 10d/p having the same configuration as in the above-mentioned TFT 10d are mentioned. The TFT 10d/n is an N-channel TFT and the TFT 10d/p is a P-channel TFT.

As shown in Fig. 9(a), like the above-mentionedprocedures, an island-shaped semiconductor layer (active layer) 20d/n and a semiconductor layer (active layer) 20d/p are formed to have a thickness of 30 to 100 nm (preferably 40 to 50 nm) on a main surface of the substrate 11.

As in the above-mentioned manner, the first insulating film 12 is formed to have a thickness of 10 to 70 nm (preferably 30 to 50 nm).

For the purpose of controlling threshold voltages of the TFTs 10d/n and 10d/p, ions of an impurity element such as boron (B) ions are implanted into the entire semiconductor layers 20d/n and 20d/p (channel doping). More specifically, after doping for the semiconductor layers 20 d/n and 20d/p is performed at 50 kV and 5 x 10¹² to 3 x 10¹³cm⁻², doping for the semiconductor layer 20d/n is performed at 50 kV and 5 x 10¹² to 3 x 10¹³ cm⁻² while the semiconductor layer 20 d/p is covered with a mask. The concentration of impurity elements in the semiconductor layer 20 d/n is about 2 x 10¹⁶ to 2 x 10¹⁷ cm⁻³, and the concentration thereof in the semiconductor layer 20d/p is about 1 x 10¹⁶ to 1 x 10¹⁷ cm⁻³.

The above-mentioned channel doping may be performed for only the semiconductor layer 20d/n or for both of the semiconductor layers 20d/n and 20d/p. In order to adjust threshold voltages of the semiconductor layers 20d/n and 20d/p to desired values, the semiconductor layers 20d/n and 20d/p are separately doped with impurities, appropriately, and thereby making a difference in impurity element concentration between the semiconductor layers 20d/n and 20d/p. If a low voltage transistor is formed on the substrate 11 in addition to the TFTs 10d/n and 10d/p, the above-mentioned channel doping may be performed after the second insulating film 13 is formed. This allows a difference in threshold value between the TFTs 10d/n and 10d/p suitable as a high voltage transistor, and the low voltage transistor. As mentioned above, it is preferable that the channel doping is performed after the first insulating film 12 is formed and before the first insulating film 12 is patterned from a viewpoint of unifying the impurity concentration among the channel regions and performing the channel doping under optimum conditions, in both of the low voltage transistor and the TFTs 10d/n and 10d/p preferable as a high voltage transistor.

As shown in Fig. 9(b), for forming the LDD region of the TFT having a GOLD structure, while the semiconductor layers 20d/n and 20d/p are covered with a resist 31d, ions of impurity elements such as phosphorus (P) ions are implanted into the semiconductor layer of the TFT having a GOLD structure at 50kV and 2 x 10¹³ to 5 x 10¹³ cm⁻² (low concentration doping for GOLD structure). The concentration of impurity elements is about 5 x 10¹⁷ to 5 x 10¹⁸ cm⁻³ in the region that are to constitute the low concentration impurity region and the source-drain region of the semiconductor layer in the TFT having a GOLD structure. Then the resist 31a is removed.

The low concentration doping for GOLD structure may be performed after the second insulating film is formed. As a result, the resistance value of the LDD region of the high voltage transistor having a GOLD structure and the resistance value of the LDD region of the low voltage transistor having a GOLD structure can be different. If the TFT having a GOLD structure is not formed on the substrate 11, this step may be omitted.

Then as shown in Fig. 9(c), as in the above-mentioned TFT 10d, the resist 31e is formed into a pattern and etched, thereby patterning the first insulating film 12. Then the resist 31e is removed.

As shown in Fig. 9(d), the second insulating film 13 is formed to have a thickness of 10 to 70 nm (preferably 30 to 50 nm), as in the above-mentioned procedures.

As in the above-mentioned procedures, a conductive film is formed by sputtering to have a thickness of 200 to 600 nm (preferably 300 to 400 nm), and then the conductive film is patterned into a desired shape by photolithography, thereby forming gate electrodes 14d/n and 14d/p as shown in Fig. 9 (e) . Thus, the gate electrode 14d/p is formed to face a region that is to constitute the channel region 21d/p and the gate electrode 14d/n is formed to face a region that is to constitute the channel region 21d/n.

Then using the gate electrodes 14d/n and 14d/p as a mask, ions of an impurity element such as phosphorus (P) ions are implanted into the semiconductor layers 20d/n and 14d/p in a self-alignment manner at 70 kV and 1 x 10¹³ to 3 x 10¹³ cm⁻² (first low concentration doping for LDD structure) . The concentration of the impurity element is about 1 x 10¹⁷ to 1 x 10¹⁸ cm⁻³ in the regions that are to constitute the low concentration impurity region 22d/n and the source-drain region 23d/n of the semiconductor layer 20d/n. As a result, the low concentration impurity region 22d/n that functions as an LDD region is formed in the TFT 10d/n. The regions that are to constitute the low concentration impurity region 22d/p and the source-drain region 23d/p of the semiconductor layer 20d/p are also doped with the impurities.

As shown in Fig. 10 (f), while the semiconductor layer 20d/n is covered with a resist 31f, ions of an impurity element such as boron (B) impurities are implanted into the semiconductor layer 20d/p (second low concentration doping for LDD structure) . In the second low concentration doping for LDD structure, the impurities (phosphorus) that has been implanted in the first low concentration doping for LDD structure needs to be canceled. Accordingly, in the second low concentration doping for LDD structures, the second layer 20d/p s doped with impurities (boron) at a concentration about twice as high as that in the first low concentration doping for LDD structure. More specifically, the second low concentration doping for LDD structure is performed at 50 kV and 2 x 10¹³ to 6 x 10¹³ cm⁻². The concentration of the impurity element is about 1 x 10¹⁷ to 1 x 10¹⁸cm⁻³ in the regions that are to constitute the low concentration impurity region 22d/p and the source-drain region 23d/p of the semiconductor layer. As a result, the low concentration 22d/p that functions as an LDD region is formed in the TFT 10d/p. Then the resist 31f is removed.

The LDD region of the TFT 10d/n is formed first in this embodiment, but the LDD region of the TFT 10d/p may be formed first.

As shown in Fig. 10(g), while the TFT 10d/p and the semiconductor layer 20d/n in a region that is to constitute the LDD region of the TFT 10d/n are covered with a resist 31g, ions of an impurity such as phosphorus (P) ions are implanted into the semiconductor layer 20d/n at 40 kV and 5 x 10¹⁵ to 1 x 10¹⁶ cm⁻² (first high concentration doping for source-drain). The concentration of the impurity element is about 1 x 10¹⁹ to 1 x 10²⁰ cm⁻³ in the region that is to constitute the source-drain region 23d/n of the semiconductor layer 20d/n. As a result, the low concentration impurity region 22d/n that functions as an LDD region is formed. The high concentration impurity region 23d/n that functions as a source-drain region is formed. As a result, the resist 31g is removed.

As shown in Fig. 10(h), while the TFT 10d/n and the semiconductor layer 20d/p in a region that is to constitute an LDD region of the TFT 10d/p are covered with a resist 31h, ions of an impurity such as boron (B) ions are implanted into the semiconductor layer 20d/p at 40 kV and 5 x 10¹⁵ to 1 x 10¹⁶ cm⁻² (second high concentration doping for source-drain). The concentration of the impurity element is about 1 x 10¹⁹ to 1 x 10²⁰ cm⁻³ in the region that is to constitute the source-drain region 23d/p of the semiconductor layer 20d/p. As a result, the low concentration impurity region 22d/p that functions as an LDD region is formed. The high concentration impurity region 23d/p that functions as a source-drain region is formed. Then the resist 31h is removed.

The source-drain region 23d/n of the TFT 10d/n is formed first, but the source-drain region 23d/p of the TFT 10d/p may be formed first.

Although the source-drain regions 23d/p and 23d/n are doped only with unipolar impurities, if a CG silicon film is formed as the semiconductor layers 20d/p and 20d/n, for gettering of the catalyst metal such as Ni, edges of the semiconductor layers 20d/p and 20d/n or a region that has no influences on TFT characteristics except for the contact parts 24d/p and 24d/n of the semiconductor layers 20d/p and 20d/n, may be doped with an impurity with reverse polarity.

Then as in the above-mentioned procedures, the interlayer insulating film 15 is formed to have a thickness of 0.5 to 1.5 µm (preferably 0.7 to 1.0 µm). Then the semiconductor layers 20d/p and 20d/n are hydrogenated and activated similarly to the above-mentioned procedures. By photolithography, the interlayer insulating film 15 and the second insulating film 13 are provided with contact holes corresponding to the source-drain regions 23d/p, 23d/n and the gate electrodes 14d/p and 14d/n as shown in Fig. 10(i).

The step of hydrogenating and activating the semiconductor layers 20d/p and 20d/n may be performed after the contact hole is formed.

Finally, a conductive film is formed by sputtering to have a thickness of 400 to 1000 nm (preferably 600 to 800 nm) and the film is patterned into a desired shape by photolithography. As shown in Fig. 10(j), the wirings 16d/p, 17d/p, 16d/p, and 17d/n, are formed. As a result, a semiconductor device including the TFT 10d/p and 10d/n of the present Embodiment can be completed.

If necessary, a multi-layer wiring structure may be formed, or a protective film that is a resin film and/or a silicon nitride film may be formed after the wirings 16d/p, 17d/p, 16d/n, 17d/n are formed.

As mentioned above, this production method can provide a semiconductor device having excellent performances and reliability and including the TFTs 10d/p and 10d/n different in conductive type on the same substrate 11 can be produced.

The present application claims priority to Patent Application No. 2007-134465 filed in Japan on May 21, 2007 under the Paris Convention and provisions of national law in a designated State, the entire contents of which are hereby incorporated by reference.

### BRIEF DESCRIPTION OF DRAWINGS

[Fig. 1]
   Fig. 1 is a schematic view showing a configuration of the semiconductor device in accordance with Embodiment 1.
   Fig. 1(a) is a cross-sectional view schematically showing the low voltage transistor having a single drain structure, taken along line X1-Y1 in Fig. 1(c).
   Fig. 1(b) is a cross-sectional view schematically showing the high voltage transistor having a single drain structure, taken along line X2-Y2 in Fig. 1(d).
   Fig. 1(c) is a schematic plan view of the low voltage transistor having a single drain structure.
   Fig. 1(d) is a schematic plan view of the high voltage transistor having a single drain structure.
[Fig. 2]
   Fig. 2 is a schematic view showing a configuration of another semiconductor device in accordance with Embodiment 1.
   Fig. 2(a) is a plan view schematically showing the low voltage transistor having a single drain structure in accordance with the modified example.
   Fig. 2(b) is a plan view schematically showing the high voltage transistor having a single drain structure in accordance with the modified example.
[Fig. 3]
   Fig. 3 is a cross-sectional view schematically showing a configuration of the semiconductor device in accordance with a modified example of Embodiment 1.
   Fig. 3 (a) shows the high voltage transistor having a GOLD structure.
   Fig. 3 (b) shows the high voltage transistor having an LDD structure.
   Fig. 3(c) shows the low voltage transistor having an LDD structure.
[Fig. 4]
   Fig. 4 is a cross-sectional view schematically showing a configuration of the semiconductor device in accordance with the modified example of Embodiment 1 during production steps.
   Fig. 4 (a) shows the low voltage transistor having an LDD structure.
   Fig. 4 (b) shows the high voltage transistor having an LDD structure.
[Fig.5]
   Fig. 5 is a graph showing a relationship between a resistance of an LDD region of a TFT having an LDD structure, and an on-state current (current driving force) and a hot carrier deterioration rate (deterioration rate of on-state current).
[Fig. 6]
   Figs. 6(a) to 6(d) are cross-sectional views schematically showing the semiconductor device in accordance with Embodiment 1 during production steps.
[Fig. 7]
   Figs. 7(e) to 7 (h) are cross-sectional views schematically showing a configuration of the semiconductor device in accordance with Embodiment 1 during production steps.
[Fig. 8]
   Fig. 8 is a cross-sectional view schematically showing a configuration of the semiconductor device in accordance with the modified example of Embodiment 1 and shows the low voltage transistor having a GOLD structure.
[Fig. 9]
   Figs. 9(a) to 9(e) are cross-sectional views schematically showing a configuration of the semiconductor device in accordance with the modified example of Embodiment 1 during production steps.
[Fig. 10]
   Figs. 10(f) to 10(j) are cross-sectional views schematically showing a configuration of the semiconductor device in accordance with the modified example of Embodiment 1 during production steps.
[Fig. 11]
   Fig. 11 is a cross-sectional view schematically showing a configuration of a conventional semiconductor device in accordance with Patent Document 1. Fig. 11 (a) shows a low voltage transistor. Fig. 11(b) shows a high voltage transistor.
[Fig. 12]
   Fig. 12 is a cross-sectional view schematically showing a configuration of a low-voltage transistor in a conventional semiconductor device in accordance with Patent Document 1 and shows a case where the first insulating film is misaligned.

### EXPLANATION OF NUMERALS AND SYMBOLS

10a to 10f, 10 d/p, 10 d/n, 110a, 110b: Thin film transistor (TFT)
11, 111: Substrate
12, 112: First insulating layer
13, 113: Second insulating layer
14a to 14f, 14 d/p, 14 d/n, 114a, 114b: Gate electrode
15, 115: Interlayer insulating film
16a to 16f and 17a to 17, 16 d/p, 16 d/n, 17 d/p, 17 d/n, 116a,
116b, 117a, 117b: Wiring
20a to 20f, 20 d/p, 20 d/n, 120a, 120b: Semiconductor layer
21a to 21f, 21 d/p, 21 d/n, 121a, 121b: Channel region
22c to 22f, 22 d/p, 22 d/n: Low concentration impurity region
23a to 23f, 23 d/p, 23 d/n, 123a, 123b: Source drain region (high concentration impurity region)
24a to 24f: Contact part
25a, 25b: Optimum impurity concentration region
26b: Low dose region
31a to 31h: Resist

## Claims

1. A semiconductor device comprising, on a main surface of a substrate, a structure in which a semiconductor layer, an insulating film, and a wiring are stacked in this order from a side of the substrate,
wherein the semiconductor layer includes a first semiconductor layer and a second semiconductor layer,
the first semiconductor layer has a first channel region and a first source-drain region having a first contact part that is in contact with the wiring,
the second semiconductor layer has a second channel region and a second source-drain region having a second contact part that is in contact with the wiring,
the insulating film includes a first insulating film and a second insulating film, stacked in this order from the side of the substrate,
the first insulating film is formed on the second channel region, except for on the first channel region and the first and second contact parts, and
the second insulating film is formed on the first channel region, a part facing the second channel region of the first insulating film, the first source-drain region except for the first contact part, and the second source-drain region except for the second contact part.

2. The semiconductor device according to Claim 1,
wherein the first semiconductor layer further has a first low concentration impurity region with an impurity concentration lower than an impurity concentration of the first source-drain region,
the second semiconductor layer further has a second low concentration impurity region with an impurity concentration lower than an impurity concentration of the second source-drain region,
the first insulating film is formed on the second channel region and the second low concentration impurity region, except for on the first channel region, the first low concentration impurity region, and the first and second contact parts,
the second insulating film is formed on:
the first channel region;
the first low concentration impurity region;
a part facing the second channel region and the second low concentration impurity region of the first insulating film;
the first source-drain region except for the first contact part; and
the second source-drain region except for the second contact part, and
the first low concentration impurity region has a sheet resistance smaller than that of the second low concentration impurity region.

3. The semiconductor device according to Claim 1,
wherein the semiconductor device further includes a first gate electrode and a second gate electrode,
the first gate electrode being formed on the second insulating film to face the first channel region,
the second gate electrode being formed on the second insulating film to face the second channel region,
the first insulating film is formed on the second channel region, a part facing the first gate electrode of an edge of the first semiconductor layer, and a part facing the second gate electrode of an edge of the second semiconductor layer, except for on the first channel region and the first and second contact parts.

4. A production method of a semiconductor device having, on a main surface of a substrate, a structure in which a semiconductor layer, an insulating film, and a wiring are stacked in this order from a side of the substrate,
the semiconductor layer including a first semiconductor layer and a second semiconductor layer,
the first semiconductor layer having a first channel region and a first source-drain region having a first contact part that is in contact with the wiring,
the second semiconductor layer having a second channel region and a second source-drain region having a second contact part that is in contact with the wiring,
the insulating film including a first insulating film and a second insulating film, stacked in this order from the side of the substrate,
the production method comprising the steps of:
forming the first insulating film on the second channel region, except for on the first channel region and the first and second contact parts; and
forming the second insulating film on the first channel region, a part facing the second channel region of the first insulating film, and the first and second source-drain regions.

5. The production method of the semiconductor device according to Claim 4,
the first semiconductor layer further having a first low concentration impurity region with an impurity concentration lower than an impurity concentration of the first source-drain region,
the second semiconductor layer further having a second low concentration impurity region with an impurity concentration lower than an impurity concentration of the second source-drain region,
the production method comprises the steps of:
forming the first insulating film on the second channel region and the second low concentration impurity region, except for on the first channel region, the first low concentration impurity region, and the first and second contact parts;
forming the second insulating film on: the first channel region; the first low concentration impurity region; a part facing the second channel region and the second low concentration impurity region of the first insulating film; and the first and second source-drain regions; and
forming a first gate electrode on a part facing the first channel region of the second insulating film and forming a second gate electrode on a part facing the second channel region of the second insulating film; and
doping the first and second semiconductor layers with an impurity using the first and second gate electrodes as a mask.

6. The production method of the semiconductor device according to Claim 4,
wherein the semiconductor device further includes: the first gate electrode that is formed on the second insulating film to face the first channel region; and
the second gate electrode that is formed on the second insulating film to face the second channel region,
wherein the production method includes a step of forming the first insulating film on the second channel region, a part facing the first gate electrode of an edge of the first semiconductor layer, and a part facing the second gate electrode of an edge of the second semiconductor layer, except for on the first channel region and the first and second contact parts.
